# EUROPEAN PATENT APPLICATION

(11) **EP 2 605 273 A2**
(43) Date of publication of application: **19.06.2013**
(21) Application number: 12197098.2
(22) Date of filing: 13.12.2012
(51) Int. Cl.: H01L 23/31, H01L 23/48, H01L 25/065

(54) **Method for forming isolation trenches in micro-bump interconnect structures and devices obtained thereof**

(30) Priority: 16.12.2011 US 201161576765 P
(71) Applicant: IMEC, 3001 Leuven (BE); Katholieke Universiteit Leuven K.U. Leuven R&D, 3000 Leuven (BE)
(72) Inventor: Zhang, Wenqi, B-3001 Leuven (BE); Wang, Wei-E, B-3001 Leuven (BE); Eneman, Geert, B-3001 Leuven (BE); Beyne, Eric, B-3001 Leuven (BE); Ivankovic, Andrej, B-3001 Leuven (BE)
(74) Representative: Pronovem

(57) **Abstract**

The invention is related to a substrate (100) suitable for use in a stack of interconnected substrates, comprising :
- A base layer (130), having a front side (135) and a back side (115) surface parallel to the plane of the base layer,
- One or more interconnect structures, each of said structures comprising :
● A via (110) filled with an electrically conductive material, said via running through the complete thickness of the base layer, thereby forming an electrical connection between said front side and back side surfaces of the base layer,
● on the back side surface (115) of the base layer : a landing pad (160) and a microbump (165) in electrical connection with said filled via,

characterized in that the backside surface (115) of said base layer (130) comprises one or more isolation ring trenches (145), each of said trenches surrounding one or more of said interconnect structures. The invention is equally related to a stack of said substrates, and to methods for producing said substrates and said stack of substrates.

## Description

### Field of the Invention

The present invention is related to the field of forming interconnect structures such as fine-pitch microbumps to be used in the stacking of semiconductor devices, in particular to the 3-dimensional integration of Integrated Circuits (ICs) by using techniques based on the 'through-silicon-via' (TSV) technology.

### State of the art.

Three-dimensional (3D) integration technology with fine-pitch Through-Silicon-Via (TSV) interconnects is a new technology that allows the integration of multiple homogeneous and heterogeneous Integrated Circuits (ICs), also referred to as chips or dies, in a single package. The technology allows multiple dies of the same or different functionality to be stacked on top of one another to create a single complete system. As a result, the length of signal interconnects carrying information between different ICs can be significantly reduced. This may result in the reduction of power required to transfer data between different systems in the 3D stack while the performance and bandwidth (transfer data rate) are increased.

3D integration requires the realization of electrical interconnections that go through the bulk of the substrate (wafer) on (or into) which the active devices are realized. These are the so-called TSV connections. One particular approach to realizing TSV connections is the so-called via-middle approach, where the TSV is realized after the fabrication of the active devices (the front-end-of-line, FEOL), just before the integration of the multilayer chip interconnect stack (the back-end-of-line, BEOL). The electrically conductive material of the TSV is typically copper or tungsten metal. The above approach allows for the fabrication of fine-pitch TSVs with diameters ranging between 1µm to 10µm. The use of the above method allows for more TSV interconnects to be fabricated in a smaller area. This may significantly benefit high bandwidth application while reducing the overall area occupied by interconnects between different ICs.

After performing the TSV processing steps, the substrate may be thinned on the backside in order to expose the TSV interconnects from the backside of the substrate in order to make a 3D stacking possible. Thinning of the substrate may be performed down to a substrate thickness of 10µm-100µm. The steps of fabricating the TSV and stacking the ICs is further explained by, for example, J. Van Olmen et al. ("3D stacked IC demonstration using a through Silicon Via First approach," Proc. IEDM 2008, pp.303-306.)

The stacking of multiple ICs (or dies) can be done by directly connecting the exposed part of the TSV interconnect of a first die to the top Back-End-of-Line (BEOL) metal of a second die. This step can be done either at the wafer level (wafer to wafer stacking) or after dicing the wafer to individual dies (die to wafer or die to die stacking). Thermal-compression is used to ensure a permanent bond between the layers of the stack. Although this method ensures that the fine pitch of the TSV is maintained throughout the stack, the temperatures required are too high and can cause reliability issues thus reducing the overall yield of the stacked device.

An alternative approach is to fabricate a fine-pitch microbump on top of the exposed TSV at the backside of the substrate, which requires lower bonding temperatures at the expense of slightly larger TSV pitch. Micro-bump interconnection is a key technology to enable the 3D package and 3D ICs by stacking thinned (< 50 µm) silicon wafers and interconnect them vertically so that they behave as a single device. However in the state of the art there are still key issues which need to be resolved in order to integrate the fine-pitch microbump interconnect structure in a reliable way with good device performance. For example, one issue is that extra local stress induced after stacking due to the fabrication of a fine pitch microbump on top of a TSV interconnects can cause mobility variations in the Si resulting in performance degradation of devices that are close to the microbump. The extra local stress induced can be attributed to the different coefficient of thermal expansion (CTE) of different materials and the shrinkage of underfill material placed between the devices.

### Summary of the invention

The present invention is related to substrates and substrate stacks, as well as to methods for producing such substrates and stacks, as disclosed in the appended claims. As such, the invention is firstly related to a substrate suitable for use in a stack of interconnected substrates, comprising :
- A base layer, having a front side and a back side surface parallel to the plane of the base layer,
- One or more interconnect structures, each of said structures comprising :
   - A via filled with an electrically conductive material, said via running through the complete thickness of the base layer, thereby forming an electrical connection between said front side and back side surfaces of the base layer,
   - on the back side surface of the base layer : a landing pad and a microbump in electrical connection with said filled via,
   **characterized in that** the backside surface of said base layer comprises one or more isolation ring trenches, each of said trenches surrounding one or more of said interconnect structures.

According to an embodiment, said trenches are filled with (i.e. the cavity of the trench is completely occupied by) a material that has a suitably low Young's modulus and a suitably low Coefficient of Thermal expansion, so as to be able to absorb a localized stress created during bonding of the substrate to another substrate in a process for forming a stack of interconnected substrates.

According to an embodiment, said material is present in said trenches and on the backside surface of said base layer.

According to an embodiment of a substrate according to the invention :
- a first layer is present on and in contact with said backside surface of the base layer,
- said isolation ring trenches are formed through said first layer, extending into the underlying base layer.

Said trenches and the surface of said first layer may be filled with a second layer formed of a material that has a suitably low Young's modulus and a suitably low Coefficient of Thermal expansion, so as to be able to absorb a localized stress created during bonding the substrate to another substrate by forming a stack of interconnected substrates.

Said first layer may be formed of a material that has a similar Young's modulus value and CTE compared to the material of the base layer into which the one or more ring trenches are etched. Said material filling said trenches may be a polyamide or BCB.

According to an embodiment, at least one of said trenches surrounds more than one interconnect structure.

A substrate according to the invention may further comprise:
- One or more integrated circuits on the front side of said base layer,
- On top of said one or more IC's, a metallization stack of Back-end-of-line interconnect layers, wherein said filled vias establish an electrical connection between said metallization stack and the microbumps on the base layer's front side.

The substrate according to the latter embodiment, may further comprise additional landing pads on the front side of said base layer, each of said additional landing pads being in electrical connection with one of said filled vias, said additional landing pads being suitable for connecting the substrate to another substrate in a stacking process.

The invention is equally related to a stack of substrates interconnected through TSV connections, comprising one or more substrates according to the invention, wherein an underfill material is present between each pair of neighbouring substrates.

In a stack of substrates according to the invention, said one or more trenches may be filled with (i.e. the cavity of the trench is completely occupied by) a material having a lower Young's modulus value than the material into which said trenches are formed, and a lower CTE value than said underfill material.

The invention is further related to a method for producing a substrate according to the invention, comprising the steps of :
- Providing a substrate comprising :
   - A base layer, having a front and a back surface parallel to the plane of the base layer,
   - One or more vias filled with an electrically conductive material, said vias running through the complete thickness of the base layer, said filled vias forming an electrical connection from the back side to the front side of the base layer,
- etching one or more ring-shaped trenches in the surface of said base layer, each of said trenches surrounding one or more of said filled vias,
- on the backside surface of the base layer : producing a landing pad and a microbump in electrical connection with said filled via, wherein each of said trenches surrounds one or more of said microbumps.

According to an embodiment, the method further comprises the step of filling said one or more trenches with (i.e. occupying the cavity of the trench completely by) a material that has a suitably low Young's modulus and a suitably low Coefficient of Thermal expansion, so as to be able to absorb a localized stress created during bonding of the substrate to another substrate in a process for forming a stack of interconnected substrates.

The method may comprise the step of depositing a single layer of said material onto the backside surface of the base layer, thereby filling said trenches (i.e. occupying the cavity of the trenches completely) and covering said backside surface with said single layer.

The method of the invention may comprise depositing a first layer onto the backside surface of said base layer, prior to the step of etching said one or more trenches, and wherein said one or more trenches are etched through said first layer and into said base layer.

Said first layer may be formed of a material that has a similar Young's modulus value and CTE compared to the material of the base layer into which the one or more ring trenches are etched.

According to a preferred embodiment, a second layer is deposited onto the first layer, thereby filling said trenches and covering said first layer, wherein the second layer is formed of a material that has a suitably low Young's modulus and a suitably low Coefficient of Thermal expansion, so as to be able to absorb a localized stress created during bonding of the substrate to another substrate in a process for forming a stack of interconnected substrates.

The invention is equally related to a method for producing a stack of interconnected substrates comprising one or more substrates according to the invention, the method comprising the steps of stacking said substrates and placing an underfill material between neighbouring substrates, and the step of curing said underfill material so as to form a bond between said neighbouring substrates.

According to an embodiment, said one or more trenches (145) are filled with (i.e. the cavity of trenches is completely occupied by) a material having a lower Young's modulus value than the material into which said trenches are formed, and a lower CTE value than said underfill material.

### Brief description of the figures

Figures 1A to 1J illustrates the method steps for forming microbump interconnect structures on the back-surface of a substrate, as well as landing pads on the front surface, according to an embodiment of the method of the invention.

Figure 2 illustrates a stack of two substrates processed by the method of the invention.

Figure 3 illustrates another stacking method of substrates processed by the method of the invention.

Figure 4 illustrates a semiconductor device package comprising a stack of substrates processed according to the method of the invention.

Figure 5 illustrates an electronic device, comprising components that may be produced by a method according to the invention.

Figure 6 illustrates an example of a stack of substrates according to the invention, leading to an optimal stress reduction.

### Detailed description of the invention

In one aspect, methods of forming isolating structures are disclosed whereby said structures are situated around a fine-pitch micro-bump interconnect structure in order to prevent the mechanical stress modulation to neighbouring active devices (i.e, field-effect transistors) located in the surrounding areas of the microbump interconnect structure. In another aspect, devices obtained by these methods are also disclosed.

The disclosed fine-pitch microbump structures, for use in 3D stacked semiconductor devices, may reduce the negative impact of these microbump structures to neighbouring devices. This is achieved by providing isolating trenches around said fine-pitch microbump structures, wherein said trenches being preferably filled with a material that has low Young's modulus and CTE to absorb the extra local stress induced after stacking of the ICs.

The disclosed devices may comprise a plurality of ICs stacked on top of one another, wherein at least one of the ICs in the stack has been manufactured using the method of forming isolating trenches around fine-pitch microbumps.

In some embodiments, a method of forming isolating trenches around fine-pitch microbump structures formed on the backside of a substrate may comprise providing a first substrate including at least one TSV extending through the backside of the substrate. The method may further comprise depositing a first layer of e.g. 500-3000 nm thickness across the backside of the substrate (i.e. covering the complete backside), etching an isolation trench around the micro-bump landing pad (the depth of said isolating trench extending to said substrate), depositing a second layer on top of said first layer for filling said isolating trenches, removing excess material from the backside of the substrate for example by a dry etch process, and exposing said TSV, selectively depositing a conductive layer on top of said TSV for forming a landing pad for the fine pitch micro-bump (said landing pad made of electrically conductive material and being located within the isolating trench), and depositing the microbump conductive layer on top of said landing pad.

In some embodiments, the substrate is made of silicon (Si) although it should be understood that other materials could be used, such as silicon on insulator (SOI), gallium arsenide (GaAs), or other materials or combinations of materials. The substrate may be processed using existing processing methods and includes at least one TSV that extends through the backside of the substrate. The substrate may be subjected to thinning, prior to or after the TSV formation (in the case of via-middle formation). The substrate may be thinned down to a thickness of a few micrometers, such as between 5-100µm. The substrate may, in some embodiments, also include active devices, such as transistors and capacitors. It may also include interconnect layers made of several levels of metallization. Each metallization level may include a dielectric layer for isolation purposes. Connections between each level of metallization may be made possible with "interconnect vias", extending from one level to the next through the dielectric material.

The first layer may be a soft material with a low Young's modules and low CTE. The first layer may comprise materials such as SiN, SiO₂, which may also serve as an insulating layer (and/or passivation layer); however, it should be understood that the first layer may comprise any other suitable material or a combination of materials that satisfy the requirements for a low Young's modules and CTE.

The isolating trench is etched around the landing pad for the microbump after the deposition of the first layer using lithographic patterning or any other suitable patterning method. The isolating trenches have a ring shape and surround at least one interconnect structure, said interconnect structure comprising the TSV, landing pad and microbump. It may also be possible that more than one interconnect structure can be surrounded by the isolating trench. The depth of the isolating trench extends through the first layer and into the substrate. In some embodiments, the substrate may be etched to a depth of a few hundreds of nanometers (100-600nm). The depth is highly dependent on the thickness of the substrate as mechanical stability might be compromised otherwise. The width of the isolating trench is in the range of 1-10µm and the distance from the microbump is in the range of 1-25µm. The width and distance from the microbump may be determined from FEM. FEM also shows that the width and proximity of the isolating etch ring to the microbump are important parameters for the effective mitigation of the stress. The FEM shows that the isolating etch ring will be most effective in mitigating stress when it is very wide and in close proximity to the microbump. The width and proximity of the isolating etch ring are limited by the fabrication technology, so it should be understood that any future advances in manufacturing will benefit this approach.

The second layer is deposited on top of the first layer to fill the isolating trenches. It comprises soft materials such as a polyamide and BenzoCycloButene (BCB), although it should be understood that any other suitable material can be used. The second layer may cover the TSV completely. Then the TSVs need to be exposed from the backside of the wafer by an etch step.

A microbump landing pad is selectively deposited on top of a TSV that will be used as intra-die interconnect and thus needs to be connected to other substrates in the stack. The landing pad is an electrically conductive material that can also be referred to as a redistribution layer (RDL). In some embodiments, the RDL material is made of highly electrically conductive materials, such as Cu or any other suitable material. In some embodiments, the RDL is of the same material as the TSV.

The microbump is deposited on top of the RDL and comprises electrically conductive materials with low melting temperature, for example Sn.

In another aspect, a method for stacking multiple substrates on top of one another is also presented. In some embodiments, the method may comprise providing at least a first substrate manufactured according to the method of fabricating isolating trenches as previously described, providing at least a second substrate including electrically conductive landing pads on the front-side of the substrate (wherein the landing pads are configured to match the location of the interconnect structure in the first substrate), creating a permanent interconnect bond between the first and second substrate using a thermal-compression method for joining the interconnect structures of the first substrate to the landing pad of said second substrate, depositing underfill (glue) material between first and second substrate, and curing the stack, thereby hardening the underfill material and mechanically stabilizing the stack of substrates. In some embodiments, before curing the stack, the process may be repeated for stacking more dies on top of existing stacks.

In some embodiments, the first substrate and second substrate are exactly the same. However, heterogeneous integration, where integration of substrates that have different functionality is also possible. In general, when stacking, the location of the interconnect structure on the first die should match the location of the interconnect structure (landing pad) on the second die. It should be understood that it is possible to use the method of stacking multiple substrates to create devices wherein the stack comprises more than two substrates.

In still another aspect, a device comprising multiple substrates is disclosed. In some embodiments, the device may comprise at least a first substrate comprising isolating trenches around the microbumps, and at least a second wafer including landing pads (interconnect structures) at compatible locations to the locations of the microbumps of the first substrate. The isolating trenches may be filled with a soft material with low Young's modules and low CTE configured for absorbing the mechanical stress generated during stacking and curing of the underfill.

The stacking can be done using different techniques. For example, the stacking techniques may include die-to-die, wherein a single diced die is stacked on top of another die; die-to-wafer, wherein a single diced die is stacked on top of a full wafer (this method requires that after stacking the wafer is diced to individual stacked devices); and wafer-to-wafer, wherein wafers are stacked on top of one another (this technique requires that the final stacked wafer is diced to individual devices).

It should also be clear that there is more than one way for stacking the substrates depending on the number of substrates in the stack. For example the different configurations for stacking may fall under the following categories: front-side to back-side, which favors more the integration of multiple substrates; and backside to back-side, which favors more the integration of two substrates.

The present invention will be further described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the term top and the like in the description and the claims are used for descriptive purposes and not necessarily for describing relative positions. It is to be understood that the terms so used are interchangeable under appropriate circumstances and that the embodiments described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of example embodiments, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments may be practiced without these specific details. In other instances, well-known methods, structures and techniques have not been shown in detail in order not to obscure an understanding of this description.

The invention will now be described by a detailed description of several embodiments. It is clear that other embodiments can be configured according to the knowledge of persons skilled in the art without departing from the true spirit or technical teaching of the invention as defined by the appended claims.

The term 'TSVs' is used throughout the description and claims to indicate a via that runs through the complete thickness of a substrate, so the meaning of TSV is not limited to a silicon substrate. Unless indicated otherwise, all example values of Young's modulus (YM) and CTE of materials are to be understood as values at room temperature (at about 25°C). All references to Young's modulus and CTE other than in the examples are to be understood as being true at least for the values of YM and CTE at room temperature, for example in the expression 'suitably low Young's modulus and a suitably low Coefficient of Thermal expansion, so as to be able to absorb a localized stress created during bonding of the substrate to another substrate' or 'a lower Young's modulus value than the material into which said trenches are formed, and a lower CTE value than the underfill material'. The terms 'bonding' or 'bonding process' as used in this description are to be understood to include all steps of a bonding process, including the step of actively or passively cooling the formed bond down to room temperature.

Micro-bump interconnection is a key technology to enable the realization of 3D package and 3D ICs devices, wherein thinned (e.g. 5-100 µm) substrates (Si or other materials) are stacked on top of one another and are interconnected vertically to form a single device, thus reducing the form factor of the device. However, one of the key concerns for this technology is the impact of stacking neighboring devices near the micro-bump. This is the result of extra local stress generation induced unavoidably due to the CTE mismatch of different materials and shrinkage of underfill (adhesive) material. When a thin substrate (IC) is stacked on another substrate (IC) using fine-pitch micro-bumps formed on top of TSVs, large stress is created. This stress is localized (in a 30-40µm range around the microbump) resulting in a non-uniform stress field, which negatively affects the performance and reliability of neighboring devices. For example, up to 40% ION change on the long-channel N-FET array at 25°C has been observed in a stack of devices wherein one of the devices is 25 µm thin.

One of the main contributors of stress after stacking is the underfill placed between the substrates in the stack to ensure mechanical stability. Underfill is an adhesive (glue) that mechanically couples the two chips or the chip and the substrate to restrain much of the differential movement between the two chips or between said chip and substrate. However, only the X-Y plane expansion is coupled, while the Z-axis expansion is free to expand and it must accommodate the properties of the µbump interconnect joints. Hence the CTE of the underfill should approximately match that of the interconnect joints. To increase the strength and further equalize thermal expansion throughout the package, silica based filler particles (in the case of a Si substrate) are dispersed throughout the underfill. In this case the typical CTE of underfill is in the range of 30-50 ppm/°C, which is close to the CTE of eutectic solder (alloy with low melting temperature), but much higher than Si, which is at 2.6 ppm/°C. Hence the adhesion between underfill and substrate is very important to prevent delamination from occurring, wherein the two dies start to separate. Moreover, after curing, underfill often shrinks in volume (∼5%). As a result a large stress (in plane and out of plane) in the package is generated. Finally, the small filler particles can be trapped at the joint interface, which will cause reliability issues.

One advantage of the disclosed methods and devices is that the mechanical stress induced during bonding may be mitigated as a result of forming isolating trenches around the fine-pitch microbump interconnect structures formed on the backside of the substrate. The isolating trenches are preferably filled with a material that has low Young's modulus and low CTE, thus absorbing the localized stress created due to the shrinkage of the underfill. In other words, the trenches are filled with a material that has a suitably low Young's modulus and a suitably low Coefficient of Thermal expansion, so as to be able to absorb a localized stress created during bonding of the substrate to another substrate in a process for forming a stack of interconnected substrates. According to a preferred embodiment, Low Young's modulus means that the YM value is lower than the YM of the material into which the isolation ring trenches are produced. Low CTE means that the CTE is lower than the CTE of the underfill material that is to be used for bonding the substrate to another substrate in a stacking process.

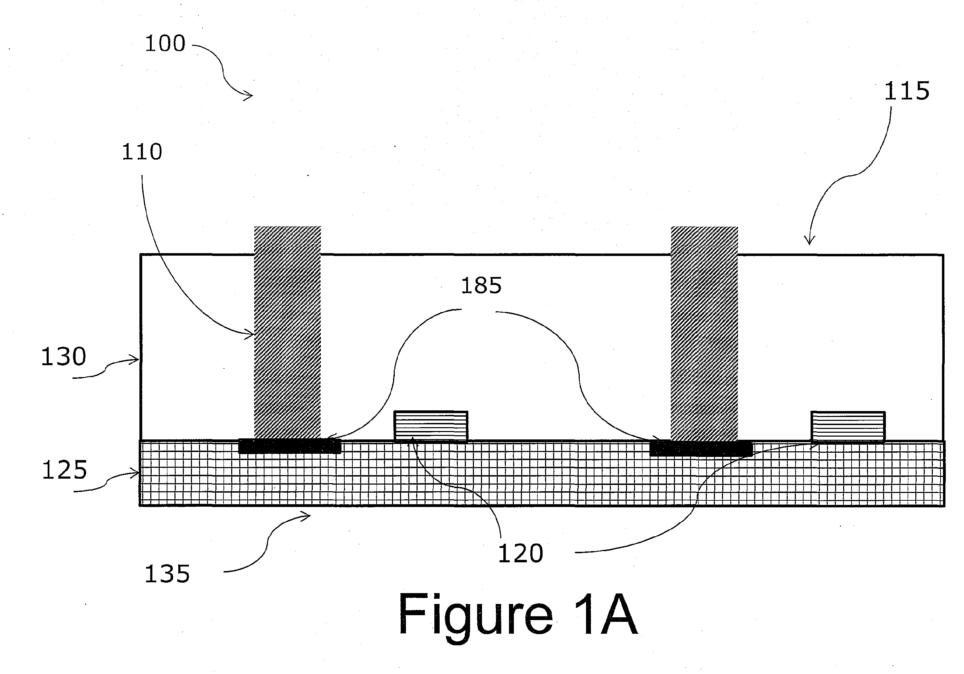

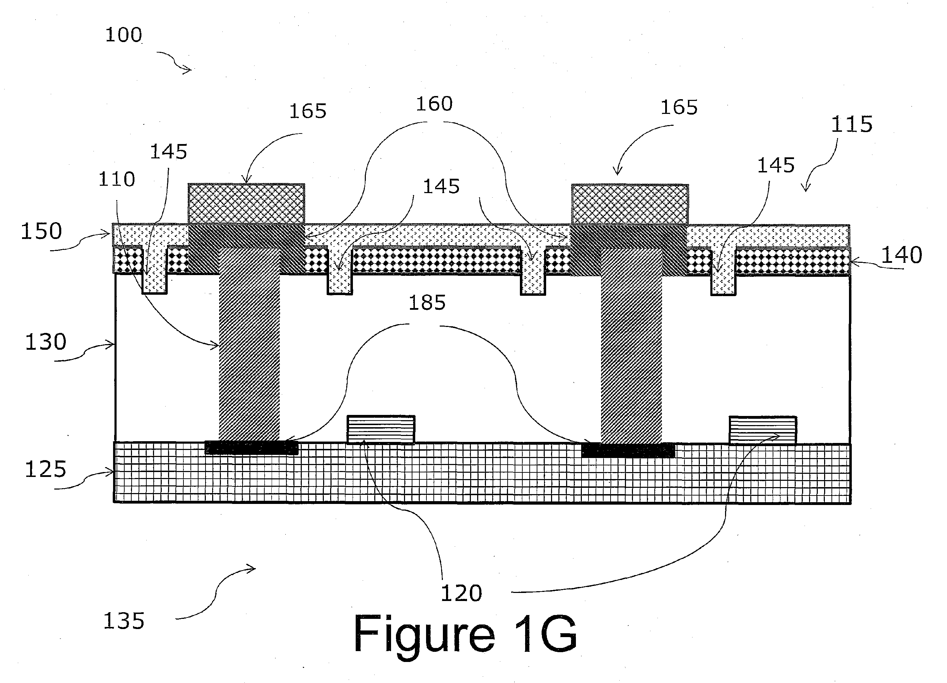

Figures 1A-1J illustrate the steps of forming isolating trenches around a microbump interconnect structure on the backside of the substrate, according to an embodiment of the method of the invention. Turning to Figure 1A, a substrate 100 is shown comprising a base layer 130. In one embodiment of the invention this base layer 130 is a silicon (Si) layer; however, it should be understood that the base layer may consist of or comprise any other suitable material or combination of materials. For reference purposes the substrate 100, and hence the base layer 130 may be viewed as having a "front side" 135 and a "back side" 115 (in the figures 1A-1J the substrate 100 is depicted always face down). It should be noted that the labels "front side" and "back side" are arbitrary. The substrate 100 comprises integrated circuits 120 formed on the front-side of the base layer 130. The integrated circuitry of IC's 120, which is also referred to in the state-of-the-art as Front-end of Line (FEOL), may include a collection of active elements such as transistors, capacitors, diodes, etc.

On top of the integrated circuitry 120, the back-end-of-line (BEOL) interconnect layers 125 comprising several levels of metallization are formed. Each metallization level includes a dielectric layer for isolation purposes. Connections between each level of metallization is made possible with "interconnect vias", extending from one level to the next through the dielectric material. The "interconnect vias" are not shown in any of the figures for simplicity and may be manufactured according to any known method of semiconductor interconnect fabrication.

The base layer 130 may comprise a semiconductor wafer upon which integrated circuitry (or FEOL) for a number of dies has been formed (or is to be formed). The semiconductor wafer may consist of or comprise any suitable material such as silicon (Si), Silicon-on-insulator (SOI), Gallium Arsenide (GaAs) or other materials or combination of materials. Alternatively, the base layer 130 may be a carrier substrate onto which a number of dies 120 have been transferred by flip-chip technology, for example, a glass interposer with logic or memory dies on it.

The substrate 100 comprises at least one metal-filled TSV 110. At least some of the TSVs 110 extend through the back side 115 of the substrate 100. Depending on the method for forming the TSVs (Via-first, Via-middle and Via-last) the base layer 130 may be thinned (e.g. to a thickness of 10µm-100µm) prior to or after the formation of the TSVs 110, for exposing said TSVs 110 through the back side 115 of the substrate 100. Throughout the description of the present invention, the TSV is assumed to have been fabricated using the Via-middle approach, wherein the TSV is formed after the Front-end-of-line but before the back-end-of-line (BEOL) 125.

At least some of the TSVs 110 extend to one of the conductors 185, which are directly connected to the BEOL 125. The conductors 185 and processes for producing them are known in the art. In this way the TSV 110 can be accessed via the Front-side 135 of substrate 100 through the BEOL 125 (see further). The conductor 185 comprises materials that are electrically conductive, such as Copper (Cu). In some embodiments, the conductor 185 is made of the same material as the TSV 110 and BEOL 125. The conductor 185 might be used to connect the TSV 110 to the integrated circuitry 120 via the BEOL 125.

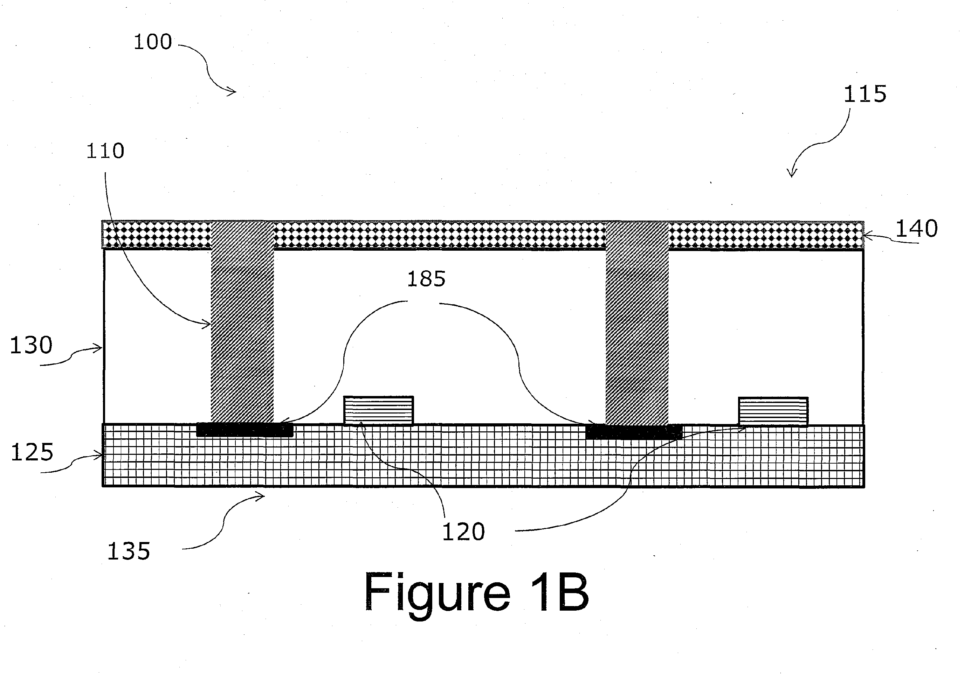

Turning now to Figure 1B, a first layer 140 preferably a thin layer of between 500nm and 3000nm in thickness, is deposited on the back side 115 of the base layer 130.

According to one embodiment, the material of the first layer 140 may have a similar Young's modulus and CTE as the base layer 130 (or of one or more layers at the backside of said base layer 130, if the base layer is itself a layered substrate). For example, if the base layer 130 is a Si-wafer (YM of 169000MPA and CTE of 2.6ppm/°C), the first layer 140 may be a silicon nitride layer (known as SiN or Si₃N₄) of the 'soft' or 'hard' type, i.e. having YM of 90000MPa or 310000MPa (depending on processing conditions), both types having a CTE of about 3.3ppm/°C. These YM and CTE values of SiN are still regarded as 'similar' to Si, in the context of this description. This SiN layer leads to a thickening of the base layer at the backside, which will act to reduce local warpage. The layer 140 may also serve as an insulating layer (and/or passivation layer). The SiN layers described above are examples of such a passivation layer. The layer 140 may also be formed of SiO₂.

According to another embodiment, the first layer 140 comprises or consists of one or more materials that are considered to be "soft" in the sense that they have a suitably low Young's modulus and a suitably low Coefficient of Thermal expansion, so as to be able to absorb a localized stress created during bonding of the substrate to another substrate in a process for forming a stack of interconnected substrates. According to a preferred embodiment, this means that these materials have a lower Young's modulus value than the material into which the isolation ring trenches 145 are to be produced (see further) and that they have a CTE that is lower than the CTE of the underfill material, to be used for bonding the substrate to another substrate in a stacking process (see further). The material into which the trenches are to be produced is the material of the base layer 130 or of one or more layers at the backside of said base layer 130, if the base layer is itself a layered substrate. An example of such a soft material is BenzocycloButene (BCB), with YM of 2900MPa and CTE of 42ppm/°C.

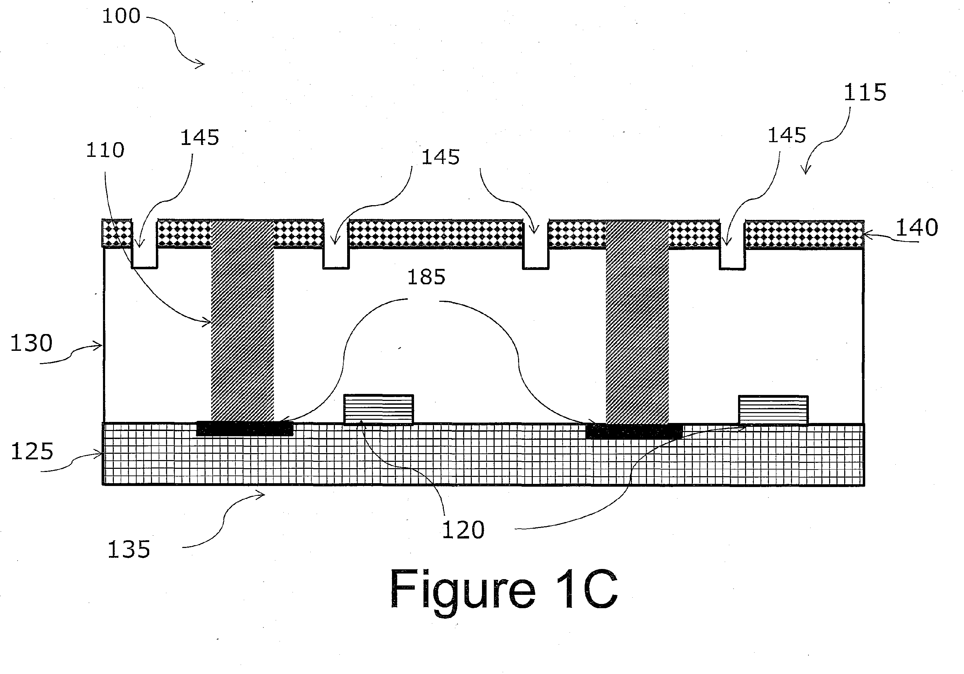

As shown in figure 1C, the first layer 140 is etched to form an isolating ring trench 145 circumventing the TSV 110. According to an embodiment, the isolating trenches have a circular ring shape with a diameter greater than the microbump diameter which will be deposited on top of the TSV. The isolating trenches may however have other ring-shapes such as rectangular, triangular, etc. The diameter or other size-defining parameter of the isolating ring trench 145 may be increased so that it surrounds more than one TSV, in the case where the microbump is formed on top of several TSVs 100 (not shown in figures). The depth of the isolating ring trench extends into the base layer 130 of the substrate 100. The depth at which the base layer 130 is etched is highly dependent on the thickness of the base layer 130. The depth cannot be a too high portion of the base layer's thickness, as mechanical stability might be compromised otherwise. In some embodiments, the base layer 130 of the substrate 100 is etched to a depth of a few hundreds of nm (e.g. 100-600nm). According to an embodiment, the width of the isolating ring trench 145 is in the range of 1-10µm and the distance from the microbump is in the range of 1-25µm, as measured from the edge of the bump to the inner edge of the trench. The width and distance from the microbump may be determined from Finite Element Modeling (FEM). FEM also shows that the width and proximity of the isolating ring trench 145 to the microbump are important parameters for the effective mitigation of the stress. The FEM showed that the isolating ring trench 145 will be most effective in mitigating stress if it is very wide and in close proximity to the microbump. The width and proximity of the isolating ring trench are limited by the fabrication technology, so it should be understood that any future advances in manufacturing will benefit this approach. Etching of the isolation ring trenches 145 can be done by any suitable technique known in the art for patterning a surface.

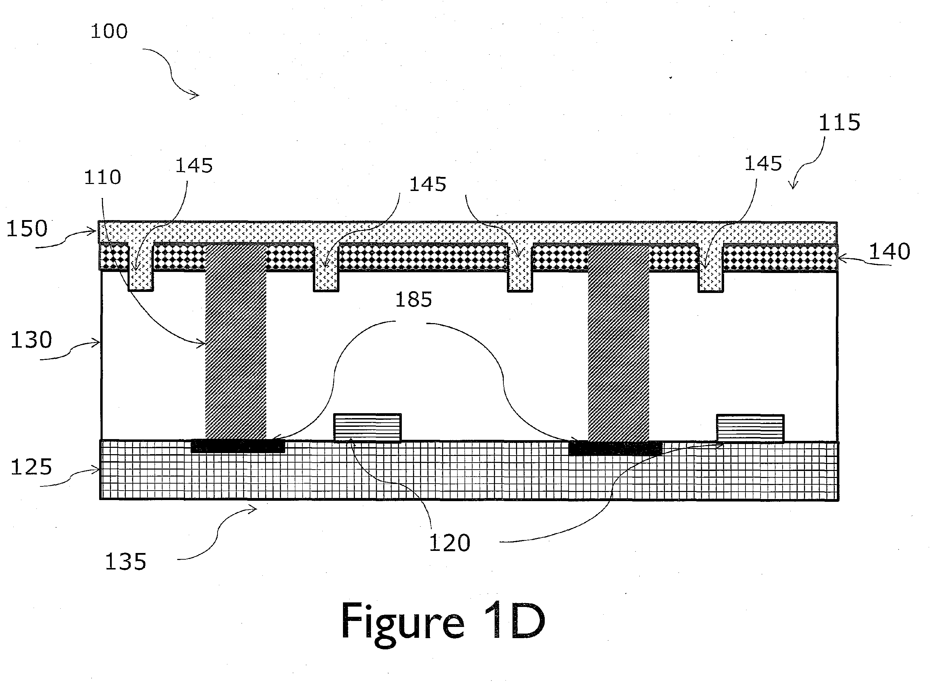

As shown in figure 1D, the isolating ring trench 145 surrounding the TSV 110 is then filled with a second layer 150. The material of the second layer 150 is a "soft" material as defined above, i.e. a material that has a suitably low Young's modulus and a suitably low Coefficient of Thermal expansion, so as to be able to absorb a localized stress created during bonding of the substrate to another substrate in a process for forming a stack of interconnected substrates. According to a preferred embodiment, this means that the material of the second layer 150 has a lower Young's modulus value than the material into which the isolation ring trench 145 is produced and a CTE that is lower than the CTE of the underfill material, to be used for bonding the substrate to another substrate in a stacking process. The second layer 150 is deposited on top of the first layer 140 thus completely filling the isolating ring trench 145 surrounding the TSV 110. The second layer 150 comprises or consists of one or more soft materials such as a polyamide or BCB, although it should be understood that any other suitable material can be used. The second layer 150 is capable of absorbing the extra local stress induced unavoidably due to the CTE mismatch of different materials and shrinkage of underfill (adhesive) material.

In an alternative embodiment, it may be possible that the isolating ring trench 145 is etched prior to the deposition of the first layer 140 and the subsequent deposition of the second layer 150. This embodiment is not illustrated in any of the figures; however it is included in the scope of the invention. It should furthermore be understood that the use of only one 'soft' layer, i.e. formed of a material that has a suitably low Young's modulus and a suitably low Coefficient of Thermal expansion, so as to be able to absorb a localized stress created during bonding of the substrate to another substrate in a process for forming a stack of interconnected substrates, may be sufficient to achieve the same goal of mitigating stress induced due to the process of stacking two or more substrates. In the latter case, said single layer is deposited, filling the trenches 145 and covering the back surface of the base layer 130. According to a preferred embodiment, said single 'soft' layer is a layer formed of a material having a lower Young's modulus value than the material into which the isolation ring trench 145 is produced and a CTE that is lower than the CTE of the underfill material, to be used for bonding the substrate to another substrate in a stacking process.

According to another embodiment not illustrated in the drawings, no further layers are deposited on top of the base layer's backside surface 115, after the trenches 145 have been etched in said backside surface. In the latter case, the presence of the trenches 145 as such results in a mitigation of stresses occurring during the bonding process.

According to a further embodiment not illustrated, only a first layer 140 is deposited on the back surface 115, and the ring trenches 145 are etched through the complete thickness of said first layer and into the surface of the base layer, while no second layer 150 is deposited into the trenches. The first layer is then preferably a layer formed of a material having a similar Young's modulus and similar CTE compared with the material into which the trenches are etched, so as to mitigate local warping effects.

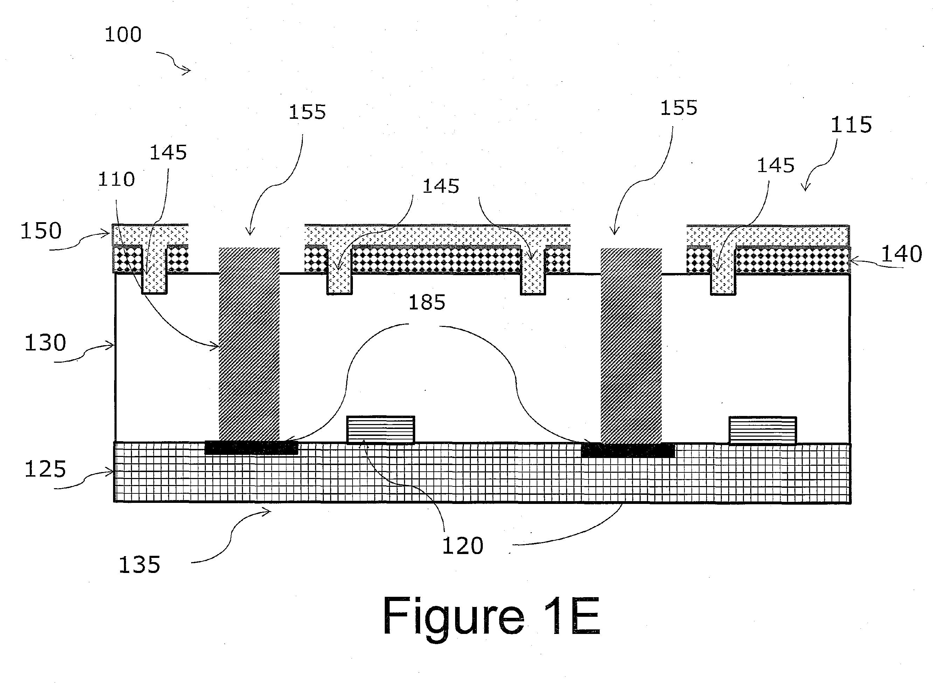

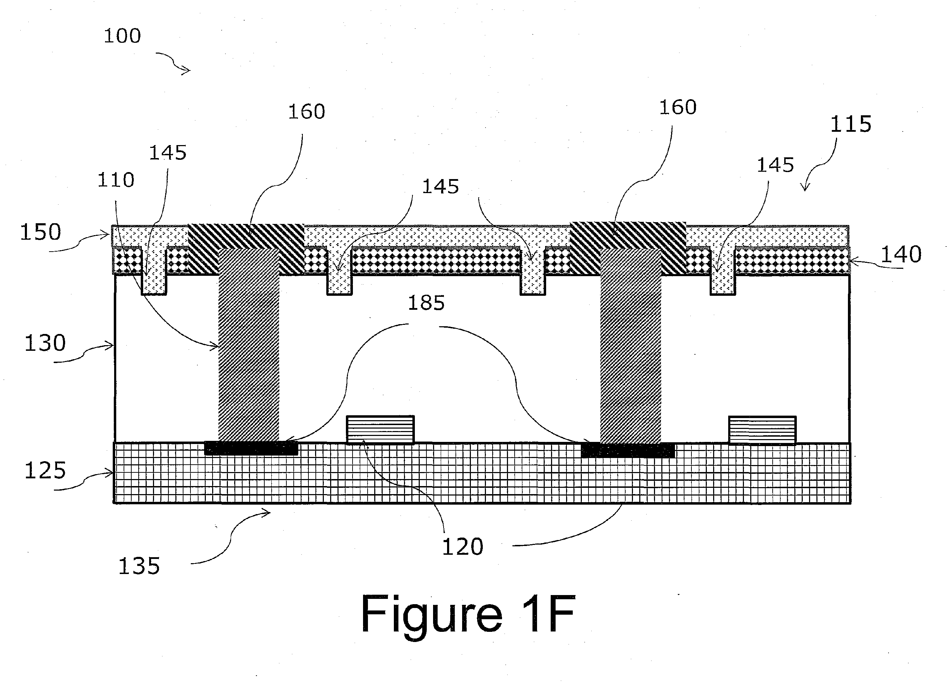

The steps illustrating the formation of the microbumps are shown in Figures 1E -1G. Once the second layer 150 has been deposited across the substrate 100, the locations where the microbump structures will be deposited are etched, forming trenches 155 and exposing the TSVs 110, as shown in Figure 1E. It should be noted that this step may be performed selectively so that only TSVs 110 that are to be used as intra-die interconnects between stacked substrates are exposed. The trench 155 is then filled with an electrically conductive material deposited on top of the TSV 110, thereby forming a landing pad 160 for the microbump, as illustrated in Figure 1F. The landing pad 160 consists of or comprises an electrically conductive material and can also be referred to as a redistribution layer (RDL). In some embodiments, the RDL material is made of highly electrically conductive materials, such as Cu or any other suitable material or a combination of materials. The RDL may be of the same material as the TSV. It should also be noted that the step of forming the landing pad 160 on top of the TSV 110 can be performed during the fabrication of the TSV 110. This highly depends on the technique used to form the TSVs (Via-first, Via-middle and Via-last).

The microbump material 165 is then deposited on top of the landing pad 160 and consists of or comprises one or more electrically conductive materials with low melting temperature, for example Sn. It should be understood that any other material or a combination of materials that are electrically conductive can also be used. One of the major advantages of using microbumps for the stacking of multiple substrates is that it requires lower temperatures for creating a permanent bond between the intra-die interconnects. It should be understood that the step of depositing the microbump 165 on top of the landing pad 160 also includes the steps of photolithography and plating (no etching here since litho includes resist development), which are considered to be known to the skilled person in the art and thus are not described in further detail.

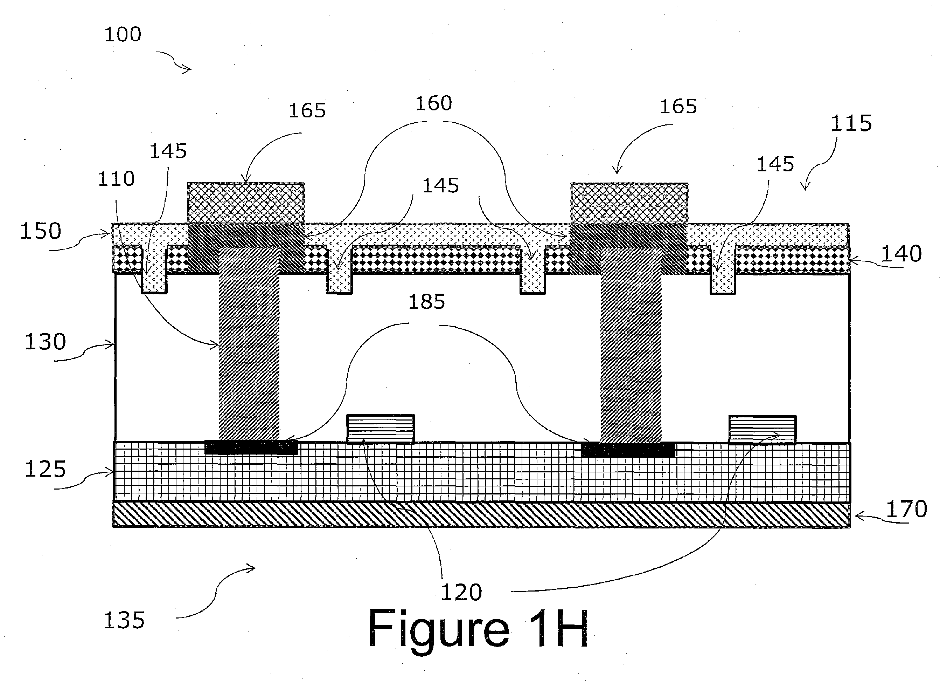

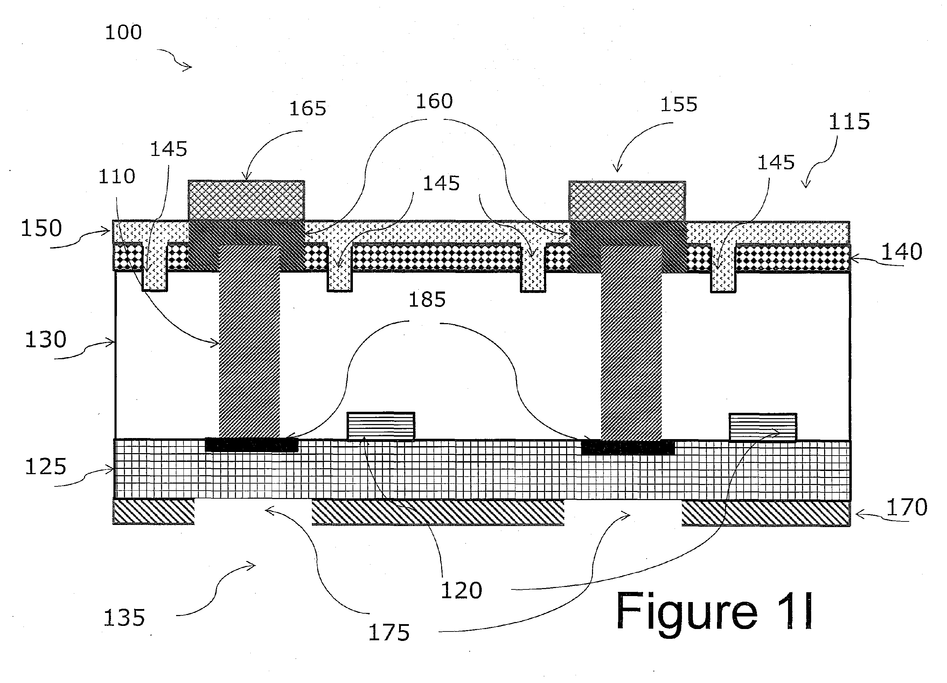

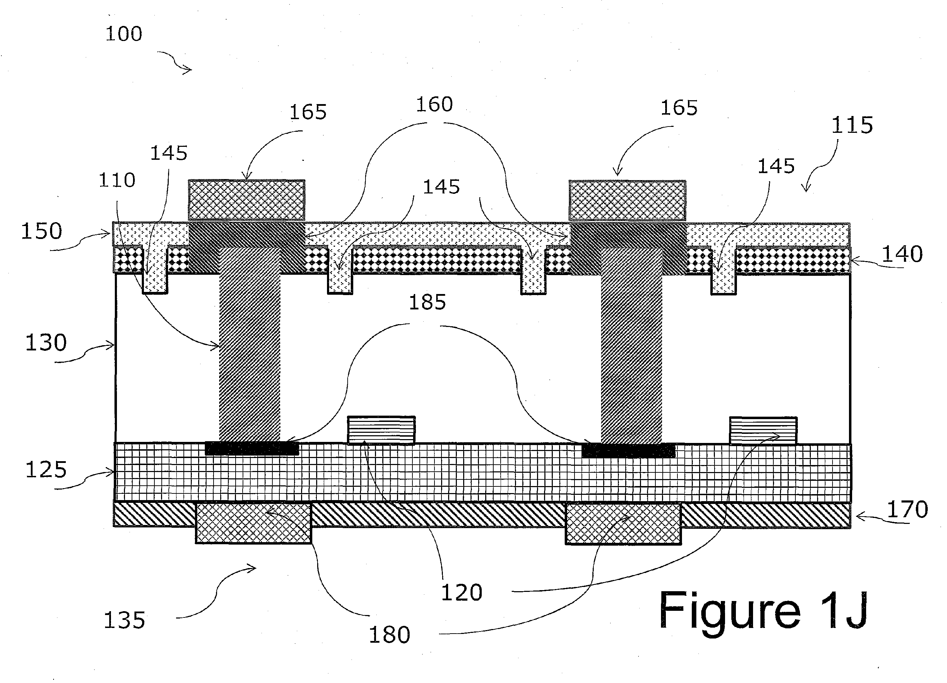

In one embodiment, it might also be necessary to access the front side of the substrate 100 so that the integrated circuit (FEOL) 120 and/or TSV can be accessed via the conductor 185. The TSV 110 is directly connected to the BEOL 125 via conductor 185 so that the TSV 110 can be accessed through the Front-side 135 of the substrate 100. Accessing the BEOL requires additional processing steps that need to be performed on the front-side of the substrate 100, which are illustrated in Figures 1H-1J. A passivation layer 170 is first deposited on the front-side 135 of substrate 100, as shown in Figure 1H. The passivation layer comprises or consists of materials that act as an insulator such as BCB, polyamide or any other material or combination of materials that have similar properties. The locations selected to access the BEOL are etched using one of a range of etching techniques and a trench 175 is created at each of said locations, exposing the top metallization layer of the BEOL, as presented in Figure 1I. The trenches 175 are subsequently filled with an electrically conductive material such as Cu, to thereby form front-side landing pads 180, as shown in Figure 1J. The front side landing pads 180 may comprise an electrically conductive layer of the same material of that of the top metallization layer to which it is connected. It should be understood that any other material providing similar properties can also be used. The skilled person will also understand that processing the front side 135 of substrate 100 requires "flipping" said substrate so that the BEOL is "face up". It is also helpful to note that the steps for Front-side processing can be performed before or after the microbump formation on the backside of substrate 100. In the case where the front side processing is done after the thinning of the wafer the substrate is "flipped" onto a "carrier" substrate (or support substrate) for mechanically supporting the thinned substrate.

The fabrication steps illustrated in Figures 1A-1H provide a substrate that can be accessed from the back side 115 using fine-pitch microbumps, wherein each microbump is surrounded by an isolation ring trench 145 to mitigate the local stress induced during stacking. The substrate 100 can also be accessed via the front side 135 of the substrate 100 by depositing an electrically conductive material for forming front side landing pads 180 on the top metallization layer of the BEOL. The front side landing pads 180 might be of the same dimensions as the back side landing pads 160.

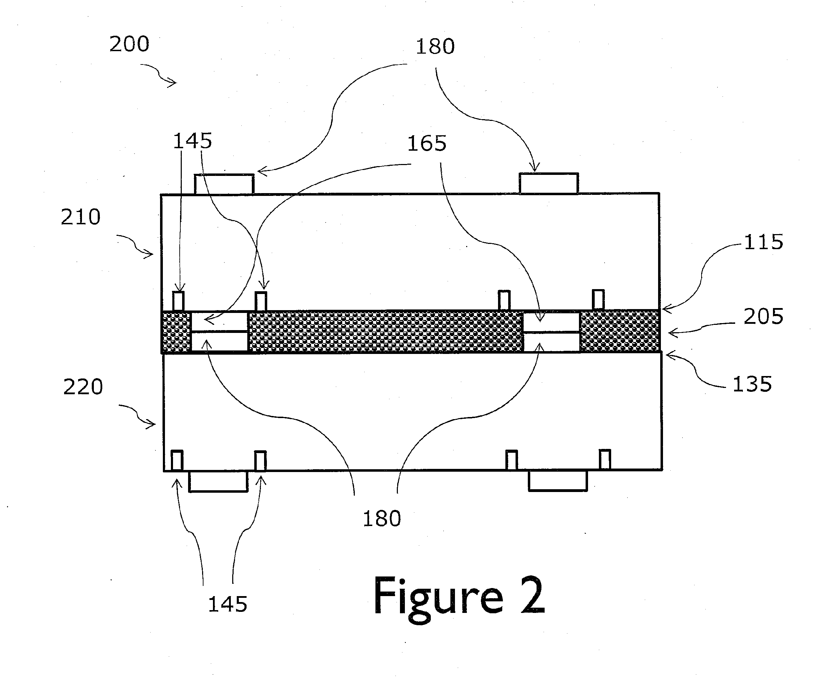

The substrate 100 may comprise one of two wafers that are to be bonded together to form a wafer stack, and wherein the microbumps 165 may be used to form backside connections for the stacked wafers (and the subsequent stacked dies that are to be diced from the bonded wafers). As stated in the claims and summary, the invention is equally related to such a stack of substrates, comprising one or more substrates according to the invention, i.e. provided with ring trenches around one or more interconnect structures. An example of such a stack is illustrated in Figure 2, wherein a stacked device 200 comprises a first substrate 210 and a second substrate 220 stacked together in a "front-to-back" stacking configuration. The backside 115 of the first substrate is bonded to the front side 135 of the second substrate 220. The stacking configuration used in the embodiment presented in Figure 2 may also be referred as "front-to-back" stacking. This approach highly favors the integration of more than two substrates. It should be noted that in this stacking configuration the first substrate 210 maybe referred to as the "top substrate" while the second substrate 220 maybe referred to as the "bottom substrate". However, it should be understood that the labels "top substrate" and "bottom substrate" are interchangeable. In addition, in the case where the stack comprises more than two substrates, it should be understood that the first substrate 210 and the second substrate 220 include isolating trench rings 145 around the microbump 165 fabricated according to the method of manufacturing isolating trenches presented herein. In the embodiment presented in Figure 2, substrate 210 has been "flipped" so that its backside 115 faces the front-side 135 of the second substrate 220. It is understood that in order to make a permanent connection between first substrate 210 and second substrate 220, the substrates need to be aligned so that the front-side landing pads 180 of the second substrate 220 directly face the microbumps 165 of the first substrate 210. Thermal-compression ensures that permanent interconnect joints are made between the front-side landing pad 180 and the microbump 165 by melting their materials and creating an alloy, such as Cu₃Sn or Cu₆Sn₅. For mechanically stabilizing the stack, underfill (adhesive) 205 is placed between the substrates in the stack. Once the stacked device 200 is completely cured, the underfill 205 is hardened so that it prevents the stacked substrates from separating. In one embodiment the first substrate 210 and the second substrate 220 may be identical. However, it should be understood that substrates of different functionality and/or composition may be stacked together. The trenches 145 in the top substrate 210 are preferably filled with a material of the above-defined 'soft' type, i.e. a material that has a suitably low Young's modulus and a suitably low Coefficient of Thermal expansion, so as to be able to absorb a localized stress created during bonding of the substrate to another substrate in a process for forming a stack of interconnected substrates. According to a preferred embodiment, this means that the trenches 145 are filled with a material having a lower Young's modulus value than the material into which the isolation ring trench 145 is etched and a CTE that is lower than the CTE of the underfill material 205.

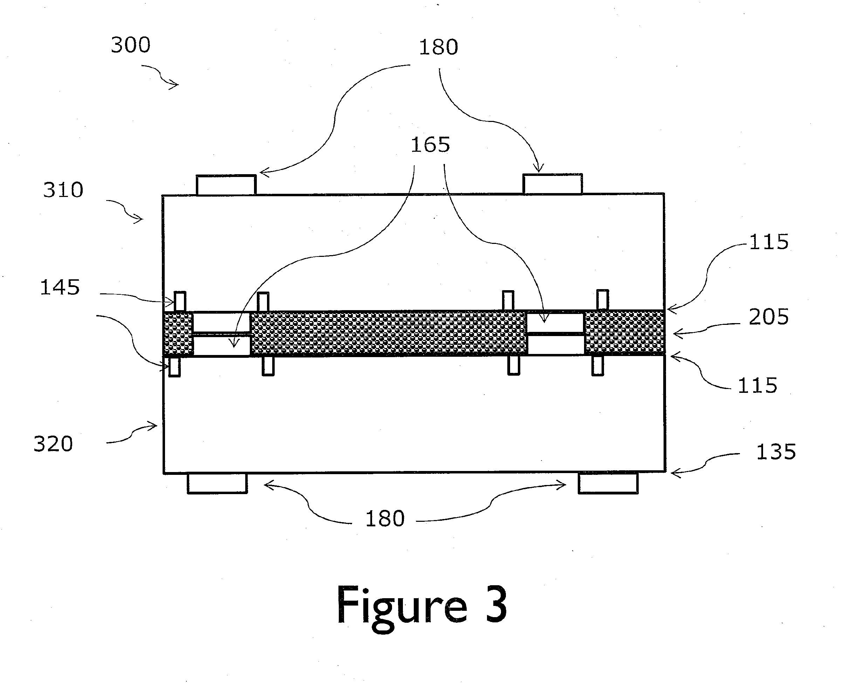

An alternative stacking configuration is presented in Figure 3. In this embodiment a stacked device 300 comprises a first substrate 310 and a second substrate 320 stacked using the backside-to-backside stacking configuration. In this case, the backside 115 of the first substrate 310 is stacked on the backside on the second substrate 320. Underfill (adhesive) material 205 is placed between the substrates. The stacked device is cured in order to harden the underfill material 205 and mechanically stabilize the substrates in the stack.

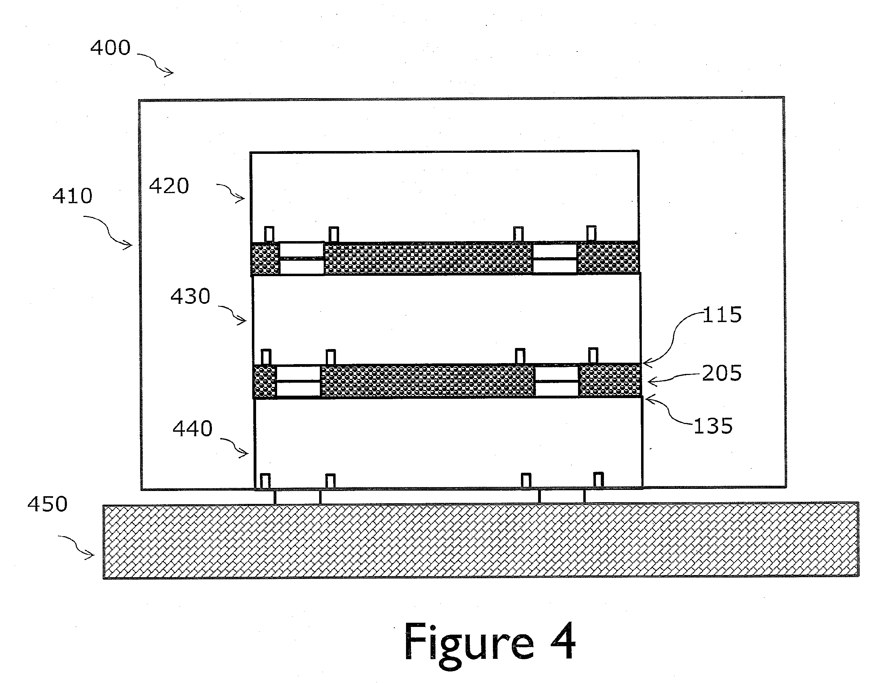

In yet another embodiment, the stack of substrates may be connected to a package substrate, to create a packaged integrated device. Figure 4 presents an example of a packaged integrated device 400 wherein a stacked device 410 comprising a first substrate 420, a second substrate 430 and a third substrate 440 is stacked on top of a package substrate 450, providing connections to other packaged devices included in an electronics systems.

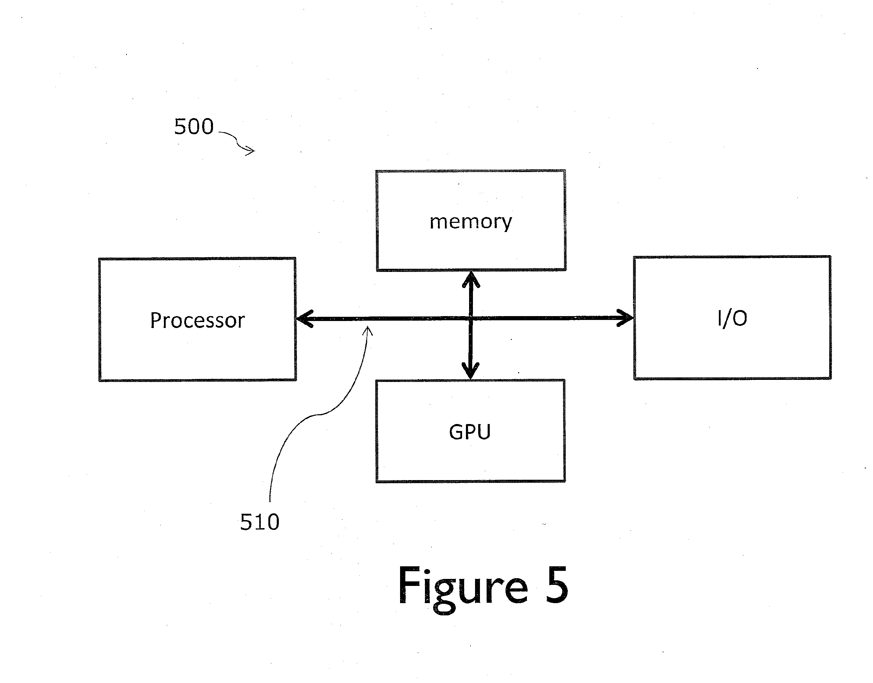

Referring to Figure 5, an example of an electronic device 500 is presented. In this example, the electronic device 500 may comprise several components, such as processing unit, storage memory, Graphics Processing Unit (GPU), I/O devices. The components communicate via a bus 510, which is used to transfer information form one component to the next component. In this example at least one of the components might include at least one packaged integrated device 400 as described in Figure 4. It should also be understood that each component may represent a substrate in a stacked device.

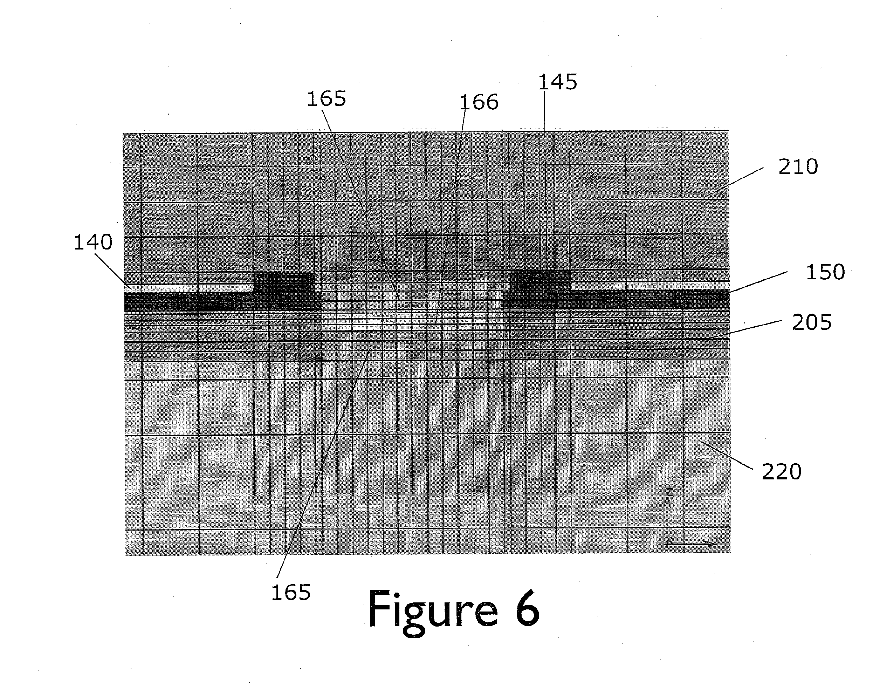

An example of a suitable dimensions and materials in a stack of substrates according to the invention is shown in detail in figure 6. The figure shows a detail of a microbump connection between a lower and upper Si-substrate 220 and 210. The following features are indicated :
- copper interconnect structures 165 comprising microbumps connected by a solder connection 166, the latter consisting of the alloy Cu₃Sn,
- a ring trench 145 surrounding the interconnect structure on the upper substrate 210,
- a SiN layer 140 on the upper substrate,
- a BCB layer 150 filling the trenches and further present on top of the SiN layer,
- underfill 205 of the type Hysol® FF2300™ referred to above,
The following dimensions lead to an optimal stress mitigation :
Thickness of top substrate 210 : 25µm, thickness of lower substrate : 700µm, width of the microbump : 30µm; width of the trench 145 : 10µm, depth of the trench : 2µm, distance between edge of trench and edge of microbump : 1µm, thickness of SiN layer : 1.5µm, thickness of BCB on top of SiN layer : 3µm, thickness of underfill : 8.5µm.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A substrate (100) suitable for use in a stack of interconnected substrates, comprising :
- A base layer (130), having a front side (135) and a back side (115) surface parallel to the plane of the base layer,
- One or more interconnect structures, each of said structures comprising :
• A via (110) filled with an electrically conductive material, said via running through the complete thickness of the base layer, thereby forming an electrical connection between said front side and back side surfaces of the base layer,
• on the back side surface (115) of the base layer : a landing pad (160) and a microbump (165) in electrical connection with said filled via,
**characterized in that** the backside surface (115) of said base layer (130) comprises one or more isolation ring trenches (145), each of said trenches surrounding one or more of said interconnect structures.

2. Substrate according to claim 1, wherein said trenches (145) are filled with a material that has a suitably low Young's modulus and a suitably low Coefficient of Thermal expansion, so as to be able to absorb a localized stress created during bonding of the substrate to another substrate in a process for forming a stack of interconnected substrates.

3. Substrate according to claim 2, wherein said material is present in said trenches and on the backside surface (115) of said base layer (130).

4. Substrate according to claim 1, wherein:
- a first layer (140) is present on and in contact with said backside surface (115) of the base layer (130),
- said isolation ring trenches (145) are formed through said first layer (140), extending into the underlying base layer (130).

5. Substrate according to claim 4, wherein said trenches and the surface of said first layer are filled with a second layer (150) formed of a material that has a suitably low Young's modulus and a suitably low Coefficient of Thermal expansion, so as to be able to absorb a localized stress created during bonding the substrate to another substrate by forming a stack of interconnected substrates.

6. Substrate according to claim 4 or 5, wherein said first layer (140) is formed of a material that has a similar Young's modulus value and CTE compared to the material of the base layer into which the one or more ring trenches (145) are etched.

7. Substrate according to any one of claims 2 to 6, wherein said material filling said trenches (145) is a polyamide or BCB.

8. Substrate according to any one of the preceding claims, wherein at least one of said trenches (145) surrounds more than one interconnect structure.

9. Substrate according to any one of the preceding claims, wherein said substrate further comprises:
- One or more integrated circuits (120) on the front side (135) of said base layer (130),
- On top of said one or more IC's, a metallization stack (125) of Back-end-of-line interconnect layers, wherein said filled vias establish an electrical connection between said metallization stack (125) and the microbumps (165) on the base layer's front side.

10. Substrate according to claim 9, further comprising additional landing pads (180) on the front side (135) of said base layer (130), each of said additional landing pads being in electrical connection with one of said filled vias (110), said additional landing pads being suitable for connecting the substrate to another substrate in a stacking process.

11. A stack of substrates interconnected through TSV connections, comprising one or more substrates according to any one of claims 1 to 10, wherein an underfill material is present between each pair of neighbouring substrates.

12. A stack of substrates according to claim 11, wherein said one or more trenches (145) are filled with a material having a lower Young's modulus value than the material into which said trenches are formed, and a lower CTE value than said underfill material.

13. A method for producing a substrate according to any one of the previous claims, comprising the steps of :
- Providing a substrate (100) comprising :
• A base layer (130), having a front (135) and a back surface (115) parallel to the plane of the base layer,
• One or more vias (110) filled with an electrically conductive material, said vias running through the complete thickness of the base layer, said filled vias forming an electrical connection from the back side to the front side of the base layer (130),
- etching one or more ring-shaped trenches (145) in the surface of said base layer, each of said trenches surrounding one or more of said filled vias (110),
- on the backside surface (115) of the base layer : producing a landing pad and a microbump in electrical connection with said filled via (110), wherein each of said trenches surrounds one or more of said microbumps.

14. Method according to claim 13, further comprising the step of filling said one or more trenches (145) with a material that has a suitably low Young's modulus and a suitably low Coefficient of Thermal expansion, so as to be able to absorb a localized stress created during bonding of the substrate to another substrate in a process for forming a stack of interconnected substrates.

15. A method for producing a stack of interconnected substrates comprising one or more substrates according to any of claims 1 to 10, the method comprising the steps of stacking said substrates and placing an underfill material between neighbouring substrates, and the step of curing said underfill material so as to form a bond between said neighbouring substrates.
